# EUROPEAN PATENT APPLICATION

(11) **EP 4 729 970 A1**
(43) Date of publication of application: **22.04.2026**
(21) Application number: 25752310.0
(22) Date of filing: 23.01.2025
(51) Int. Cl.: G01R 31/392, G01R 31/382, G01R 31/396, G01R 19/12, G01R 19/165

(54) **BATTERY DIAGNOSIS APPARATUS AND BATTERY DIAGNOSIS METHOD**

(30) Priority: 06.02.2024 KR 20240018379; 22.01.2025 KR 20250009688
(71) Applicant: LG Energy Solution, Ltd., Seoul 07335 (KR)
(72) Inventor: HAM, Seok-Won, Daejeon 34122 (KR); BAE, Yoon-Jung, Daejeon 34122 (KR); JEONG, Hee-Seok, Daejeon 34122 (KR)
(74) Representative: Goddar, Heinz J.
(86) International application number: PCT/KR2025/001340
(87) International publication number: WO 2025/170262

(57) **Abstract**

A battery diagnosis apparatus and a battery diagnosis method are disclosed. The battery diagnosis method according to the present disclosure includes detecting a degradation feature point located within a reference voltage range from a differential capacity profile representing voltage-differential capacity relationship characteristics of a battery cell in the reference voltage range, updating degradation history information indicating a change history of at least one of position information or type information of the degradation feature point based on a result of detecting the degradation feature point, and diagnosing a degradation state of the battery cell based on the updated degradation history information.

## Description

### TECHNICAL FIELD

The present disclosure relates to degradation diagnosis for batteries.

This application is based on and claims priority to Korean Patent Application No. 10-2024-0018379 filed on February 6, 2024 and Korean Patent Application No. 10-2025-0009688 filed on January 22, 2025 in the Republic of Korea, the disclosures of which are incorporated herein by reference.

### BACKGROUND

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be charged and discharged repeatedly.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

There are many different techniques for battery degradation diagnosis. In particular, Differential Capacity Analysis (DCA) is usually used to understand battery degradation or abnormality based on parameters (for example, voltage and current) that can be observed from the outside of batteries.

In the battery diagnosis using DCA, it is necessary to detect feature point(s) in a differential capacity profile (also referred to as a 'V-dQ/dV curve') as a key factor.

In relation to this, polarization closely related to charge/discharge characteristics of batteries rely on many resistance components (for example, Ohm resistance, charge transfer resistance, spreading resistance) of batteries, and as batteries degrade, polarization gets worse. For example, there is a difference between open circuit voltage (OCV) and closed circuit voltage (CCV) in batteries during charging or discharging, and one of causes is polarization-induced overpotential.

The polarization causes a shift in the voltage range in which a redox reaction of at least one positive electrode active material and/or at least one negative electrode active material of batteries mainly occurs, or a change in the intensity of redox reaction in the corresponding voltage range, according to the magnitude of polarization. The degradation-induced change in charge/discharge characteristics may change the position of at least one feature point as well as the type of the feature point.

However, the DCA-based diagnosis detects a specific type (for example, peak) of feature point for each diagnosis cycle, and only uses position information (for example, a voltage value and/or a differential capacity value) of the detected feature point, and thus has a disadvantage of limited diagnosis precision.

### DISCLOSURE

### Technical Problem

The present disclosure is directed to providing a battery diagnosis apparatus and a battery diagnosis method for precisely diagnosing a degradation state of a battery that cannot be directly observed from the outside by analyzing a change history of at least one of feature point position or type identified from differential information of charge/discharge characteristics of the battery.

These and other objectives and advantages of the present disclosure may be understood from the following description and will become apparent from the exemplary embodiments of the present disclosure. Also, it will be easily understood that the objectives and advantages of the present disclosure may be realized by the means set forth in the appended claims and a combination thereof.

### Technical Solution

A battery diagnosis method according to an aspect of the present disclosure includes detecting a degradation feature point located within a reference voltage range from a differential capacity profile representing voltage-differential capacity relationship characteristics of a battery cell in the reference voltage range; updating degradation history information indicating a change history of at least one of position information or type information of the degradation feature point based on a result of detecting the degradation feature point; and diagnosing a degradation state of the battery cell based on the updated degradation history information.

The battery diagnosis method may further include determining a voltage profile of the battery cell with respect to the reference voltage range by curve fitting a voltage-current data set acquired with a change in voltage of the battery cell over the reference voltage range; and acquiring the differential capacity profile by differentiating the voltage profile.

The diagnosing of the degradation state of the battery cell may include diagnosing that a positive electrode capacity loss of the battery cell occurred when a first tendency of the degradation feature point to get close to a reference line above the reference line is identified from the updated degradation history information.

The diagnosing of the degradation state of the battery cell may further include determining a positive electrode capacity loss ratio of the battery cell by comparing a current differential capacity value of the degradation feature point with an initial differential capacity value when it is diagnosed that the positive electrode capacity loss occurred in the battery cell.

The diagnosing of the degradation state of the battery cell may include diagnosing that in addition to the positive electrode capacity loss of the battery cell, an additional loss of lithium inventory occurred when a second tendency of the degradation feature point to move away from the reference line below the reference line is identified from the updated degradation history information.

The diagnosing of the degradation state of the battery cell may further include determining a lithium inventory loss ratio of the battery cell according to a difference between a current differential capacity value of the degradation feature point and a differential capacity value of the reference line when it is diagnosed that the loss of lithium inventory of the battery cell occurred.

The battery diagnosis method may further include determining the reference voltage range based on an initial differential capacity profile of the battery cell, before determining the differential capacity profile of the battery cell with respect to the reference voltage range.

The determining of the reference voltage range may include detecting a main feature point which is a peak located within a predetermined voltage range of interest from the initial differential capacity profile; detecting a first auxiliary feature point located on lower voltage side than the main feature point and a second auxiliary feature point located on higher voltage side than the main feature point; and determining the reference voltage range to be equal to a voltage range between the first auxiliary feature point and the second auxiliary feature point.

The reference line may be a straight line passing through the first auxiliary feature point and the second auxiliary feature point.

A battery diagnosis apparatus according to another aspect of the present disclosure includes a processor to generate a differential capacity profile representing voltage-differential capacity relationship characteristics of a battery cell in a reference voltage range. The processor is configured to detect a degradation feature point located within the reference voltage range from the differential capacity profile. The processor is configured to update degradation history information indicating a change history of at least one of position information or type information of the degradation feature point based on a result of detecting the degradation feature point. The processor is configured to diagnose a degradation state of the battery cell based on the updated degradation history information.

The processor may be configured to diagnose that a positive electrode capacity loss of the battery cell occurred when a first tendency of the degradation feature point to get close to a reference line above the reference line is identified from the updated degradation history information.

The processor may be configured to diagnose that in addition to the positive electrode capacity loss of the battery cell, an additional loss of lithium inventory occurred when a second tendency of the degradation feature point to move away from the reference line below the reference line is identified from the updated degradation history information.

The processor may be configured to determine the reference voltage range based on an initial differential capacity profile of the battery cell, before determining the differential capacity profile.

A battery pack according to still another aspect of the present disclosure includes the battery diagnosis apparatus.

A battery system according to further another aspect of the present disclosure includes the battery diagnosis apparatus.

### Advantageous Effects

According to at least one of the embodiments of the present disclosure, the degradation state of the battery that cannot be directly observed from the outside may be precisely diagnosed by analyzing the change history of at least one of feature point position or type identified from differential information of charge/discharge characteristics of the battery.

In addition, according to at least one of the embodiments of the present disclosure, it may be possible to provide detailed information about the main cause of battery degradation.

In addition, according to at least one of the embodiments of the present disclosure, when the diagnosis result of the degradation state reveals that battery degradation is likely to be accelerated (for example, loss of lithium inventory), additional control measures may be taken to control or mitigate the likely accelerated battery degradation.

The effects of embodiments of the present disclosure are not limited to the aforementioned effects, and these and other effects will be clearly understood by those skilled in the art from the appended claims.

### BRIEF DESCRIPTION OF THE DRAWINGS

The accompanying drawings illustrate exemplary embodiments of the present disclosure and together with the following detailed description, serve to provide a better understanding of the technical aspect of the present disclosure, and thus the present disclosure should not be construed as being limited to the drawings.
FIG. 1 is a diagram referenced in briefly describing a battery diagnosis apparatus according to the present disclosure.
FIG. 2 is an exemplary graph referenced in describing a change in capacity-voltage relationship characteristics as a battery degrades.
FIGS. 3 and 4 are exemplary graphs referenced in describing a change in voltage-differential capacity relationship characteristics as a battery degrades.
FIG. 5 is a flowchart referenced in briefly describing a battery diagnosis method according to another embodiment of the present disclosure.
FIG. 6 is a flowchart schematically showing sub-steps that may be included in step S500 of FIG. 5.
FIG. 7 is a diagram referenced in describing the method of FIG. 6.
FIG. 8 is a flowchart schematically showing sub-steps that may be included in step S540 of FIG. 5.
FIG. 9 is a flowchart schematically showing sub-steps that may be included in step S550 of FIG. 5.

### BEST MODE

Hereinafter, exemplary embodiments of the present disclosure will be described in detail with reference to the accompanying drawings. Prior to the description, it should be understood that the terms or words used in the specification and the appended claims should not be construed as being limited to general and dictionary meanings, but rather, should be interpreted based on the meanings and concepts corresponding to the technical aspects of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspects of the present disclosure but not intended to be limiting, so it should be understood that a variety of other equivalents and modifications could have been made thereto at the time the application was filed.

The terms including the ordinal numbers such as "first", "second" and the like, are used to distinguish one element from another among various elements, but not intended to limit the elements.

Unless the context clearly indicates otherwise, the terms "comprise" and "include" when used in this specification, specify the presence of stated elements, but do not preclude the presence or addition of one or more other elements. Additionally, the term "unit" as used herein refers to a processing unit of at least one function or operation, and may be implemented by hardware and software either alone or in combination.

In addition, throughout this specification, it will be further understood that when an element is referred to as being "connected to" another element, it can be directly connected to the other element or intervening elements may be present.

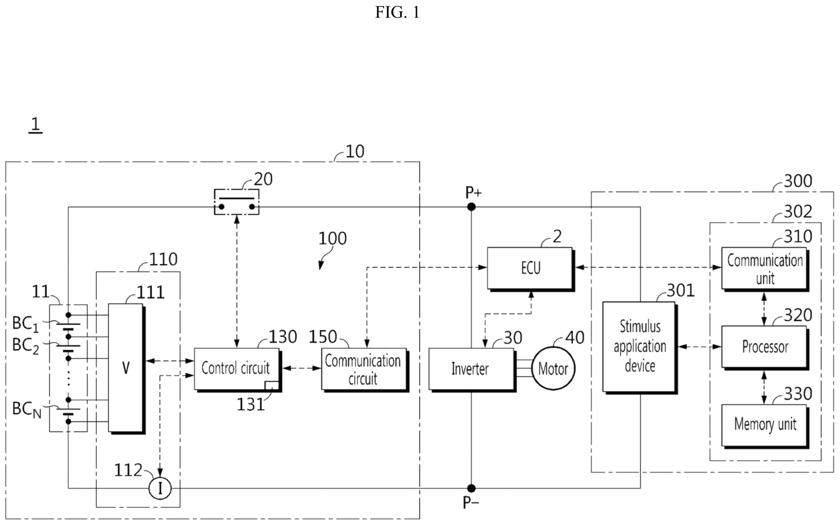

FIG. 1 is a diagram referenced in briefly describing a battery diagnosis apparatus according to the present disclosure.

Referring to FIG. 1, a battery system 1 includes a system controller 2, a battery pack 10, an inverter 30 and an electric motor 40. Charge/discharge terminals P+, P- of the battery pack 10 may be electrically coupled to a charging station 300 through a charging cable. The battery system 1 is not limited to a particular type, and may include, for example, any electrical system using a battery 11 as a power source such as an electric vehicle.

The system controller 2 (for example, an Electronic Control Unit (ECU)) is configured to transmit a key-on signal to a battery management system 100 in response to a user's changing an ignition button (not shown) of the battery system 1 to an ON-position. The system controller 2 is configured to transmit a key-off signal to the battery management system 100 in response to the user's changing the ignition button to an OFF-position. The charging station 300 may supply a charge power selected from constant power, constant current and constant voltage through the charge/discharge terminals P+, P- of the battery pack 10 via communication with the system controller 2.

The battery pack 10 includes the battery 11 and the battery management system 100. The battery pack 10 may further include a relay 20.

The battery 11 includes at least one battery cell BC. FIG. 1 shows the battery 11 including a plurality of battery cells BC₁~BC_{N} (N is a natural number of 2 or greater) connected in series by way of illustration. The plurality of battery cells BC₁~BC_{N} may be provided with the same electrochemical specification. Hereinafter, in describing the common description of the plurality of battery cells BC₁~BC_{N}, the symbol 'BC' is affixed to the battery cell. The battery cell BC may be diagnosed by the charging station 300 or a cloud server (not shown).

The battery cell BC may include any electrochemical device that can be repeatedly charged and discharged, including lithium-ion cells and is not limited to a particular one. A positive electrode active material of the battery cell BC may include, for example, lithium metal composite oxide such as LiNi_{8/10}Co_{1/10}Mn_{1/10}O₂. A negative electrode active material of the battery cell BC may include, for example, carbon-based materials (for example, graphite).

The charging station 300 may perform a diagnosis process for the battery cell BC through collaboration with the inverter 30 having a discharge function.

The relay 20 is electrically connected in series to the battery 11 through the power path connecting the battery 11 and the inverter 30. FIG. 1 shows the relay 20 connected between a positive terminal of the battery 11 and the charge/discharge terminal P+. The relay 20 is controlled to turn on/off in response to the switching signal from the battery management system 100. The relay 20 may include a mechanical contactor that turns on or off by the magnetic force of a coil or a semiconductor switch such as Metal Oxide Semiconductor Field Effect transistor (MOSFET).

The inverter 30 is provided to convert direct current (DC) power from the battery 11 included in the battery pack 10 to alternating current (AC) power in response to the command from at least one of the battery management system 100, the system controller 2 or the battery diagnosis apparatus 302. The electric motor 40 operates using the AC power from the inverter 30. The electric motor 40 may include, for example, a 3-phase AC motor. The components in the battery system 1 that is supplied with the discharge power of the battery 11, including the inverter 30 and the electric motor 40 may be referred collectively to as an electrical load.

The battery management system 100 includes a sensing unit 110 and a control circuit 130. The battery management system 100 may further include a communication circuit 150.

The sensing unit 110 includes a voltage sensor 111. The sensing unit 110 may further include a current sensor 112.

The voltage sensor 111 is connected to the positive and negative terminals of the battery cell BC, and configured to detect a voltage of the battery cell BC, and generate a voltage signal indicating a measurement value of the detected voltage. The voltage sensor 111 may include one of known voltage detection devices such as a voltage measurement IC or a combination thereof.

The current sensor 112 is connected in series to the battery 11 through the current path between the battery 11 and the inverter 30. The current sensor 112 is configured to detect the current (referred to as 'charging/discharging current') flowing through the battery 11, and generate a current signal indicating a measurement value of the detected current. Because the plurality of battery cells BC₁~BC_{N} is connected in series, the current flowing in the battery 11 is the same as the current flowing in the battery cell BC. The current sensor 112 may include one of known current detection devices such as a shunt resistor or a Hall-effect device or a combination thereof.

The communication circuit 150 is configured to support wired or wireless communication between the control circuit 130 and the system controller 2 and/or the charging station 300. The wired communication may include, for example, controller area network (CAN) communication, and the wireless communication may include, for example, Zigbee or Bluetooth communication. The communication protocol may include any type of communication protocol that supports the wired/wireless communication between the control circuit 130 and the system controller 2 and is not limited to a particular one. The communication circuit 150 may include an output device (for example, a display, a speaker) to provide information received from the control circuit 130 and/or the system controller 2 into a recognizable format for the user (driver).

The control circuit 130 is operably coupled to the relay 20, the sensing unit 110 and the communication circuit 150. In this specification, "operably coupled" refers to direct/indirect connection to enable signal transmission and reception in one or two directions.

The control circuit 130 may collect the voltage signal from the voltage sensor 111 and the current signal from the current sensor 112. In this specification, a detection signal may be the term indicating the voltage signal alone or both the voltage signal and the current signal. That is, the control circuit 130 may convert and record each analogue signal collected from the voltage sensor 111 and the current sensor 112 into a digital value by using an Analog to Digital Converter (ADC) equipped therein. Alternatively, each of the voltage sensor 111 and the current sensor 112 may include the ADC therein, and transmit the digital value to the control circuit 130.

The control circuit 130 may be also referred to as a 'battery controller' and be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing other functions.

A memory 131 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory 131 may store data and programs required for the computation operation by the control circuit 130. The memory 131 may store data indicating the computation operation result by the control circuit 130.

When the relay 20 is turned on, the battery 11 is in a charge mode or a discharge mode. When the relay 20 is turned off while the battery 11 is in use in the charge mode or the discharge mode, the battery 11 changes to a rest mode.

The control circuit 130 may turn on the relay 20 in response to the key-on signal. The control circuit 130 may turn off the relay 20 in response to the key-off signal. The key-on signal is a signal that requests a change from rest to charge or discharge. The key-off signal is a signal that requests a change from charge or discharge to rest. Alternatively, instead of the control circuit 130, the system controller 2 may take responsibility for on-off control of the relay 20.

In this specification, measurement data (for example, time series) of a parameter may indicate a time-dependent change history of the parameter. Additionally, a profile (or a curve) indicating a correspondence relationship between two parameters for the same period of time may be a mapping of measurement data for the two parameters in the form of a two-dimensional (2D) graph, or a polynomial equation obtained by applying a predetermined curve fitting logic to the mapped set of measurement data. Here, the degree of the highest degree term of the polynomial equation may be preset.

The battery diagnosis apparatus 302 includes a processor 320. The battery diagnosis apparatus 302 may further include at least one of a communication unit 310 or a memory unit 330.

The charging station 300 includes a stimulus application device 301 and may further include the battery diagnosis apparatus 302. Alternatively, the battery diagnosis apparatus 302 may be independent from the charging station 300. For example, the battery diagnosis apparatus 302 may be included in the cloud server (not shown). The cloud server may be at a remote location from the charging station 300. In this case, the communication unit 310 of the battery diagnosis apparatus 302 may perform diagnosis procedures for the battery cell BC via remote communication with the stimulus application device 301 and/or the battery system 1.

According to an embodiment, the battery diagnosis apparatus 302 may be included in the battery pack 10. In this case, the battery management system 100 may be omitted from the battery pack 10. Instead, the processor 320 may perform all the functions of the control circuit 130 of the battery management system 100. For example, the communication unit 310 may be included as a subordinate of the processor 320 and take responsibility for all the functions of the communication circuit 150 of the battery management system 100. In addition, the communication unit 310 may collect measurement information including at least one of the voltage signal and the current signal from the sensing unit 110.

The stimulation application device 301 may include a charger to provide charge power to the battery pack 10. The stimulation application device 301 may further include a discharger to release discharge power from the battery pack 10. The stimulation application device 301, alone or in cooperation with the inverter 30, may apply a variety of electrical stimuli for diagnosis of the battery cell BC to the battery cell BC.

The communication unit 310 is configured to support wired or wireless communication between the processor 320 and the system controller 2. The communication unit 310 may transmit the diagnosis result of the battery cell BC done by the processor 320 to the battery system 1.

The processor 320 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors, or electrical units for performing other functions.

The memory unit 330 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory unit 330 may store data and programs required for the diagnosis procedures performed by the processor 320. The memory unit 330 may store data indicating the computation operation result by the processor 320. The memory unit 330 may store datasets and software used to diagnose the degradation state of the battery cell BC. The memory unit 330 may be included as a subordinate of the processor 320.

The processor 320 may determine voltage, current, capacity, and State of Charge (SOC) of the battery cell BC based on the detection signal. The capacity of the battery cell BC represents the amount of charge stored in the battery cell BC and may be referred to as 'residual capacity'. The processor 320 may determine the capacity of the battery cell BC by accumulating the detection value of the current of the battery cell BC at a predetermined time interval. The SOC of the battery cell BC represents a ratio of the capacity of the battery cell BC to the maximum capacity (also referred to as 'full charge capacity') of the battery cell BC and is generally expressed as 0 to 1 or 0 to 100%. The maximum capacity of the battery cell BC gradually decreases as the battery cell BC degrades.

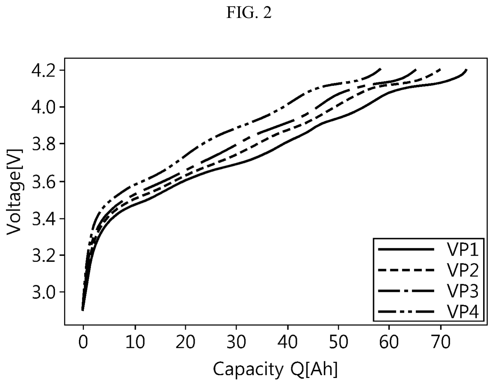

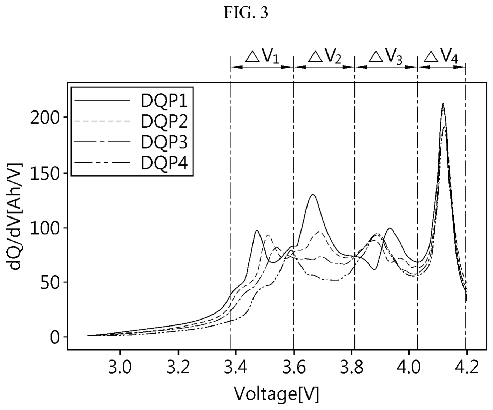

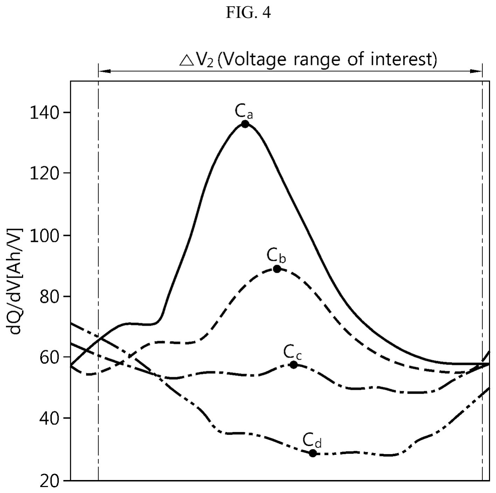

FIG. 2 is an exemplary graph referenced in describing a change in capacity-voltage relationship characteristics as the battery degrades, and FIGS. 3 and 4 are exemplary graphs referenced in describing a change in voltage-differential capacity relationship characteristics as the battery degrades. For convenience of description, each of voltage profiles VP1, VP2, VP3, VP4 shown in FIG. 2 is acquired from the result of a charge/discharge test performed by degrading test cell(s) purposely. The charge/discharge test may involve, for example, cyclical repetition of Constant Current (CC)-Constant Voltage (CV) charging, primary resting, CC discharging and secondary resting within a predetermined allowable voltage range. The test cell(s) may be manufactured with the same specifications as the electrochemical performance of the fresh battery cell BC, and may be referred to as a 'sample battery cell'.

Referring to FIG. 2, the voltage profiles VP1 to VP4 show the capacity-voltage relationship characteristics of the test cell in that order with increasing level of degradation of the test cell.

Specifically, the voltage profile VP1 represents capacity-voltage relationship characteristics of the test cell during CC charging at the initial stage of the charge/discharge test. The voltage profile VP2 represents capacity-voltage relationship characteristics of the test cell at the beginning of life (BOL) where the charge/discharge test is performed a first number of repetitions (for example, 100 times). The voltage profile VP3 represents capacity-voltage relationship characteristics of the test cell in the middle of life (MOL) where the charge/discharge test is performed a second number of repetitions (for example, 300 times) that is greater than the first number of repetitions. The voltage profile VP4 represents capacity-voltage relationship characteristics of the test cell at the end of life (EOL) where the charge/discharge test is repeated a third number of repetitions (for example, 600 times) that is greater than the second number of repetitions. For reference, the end of life is a state that requires replacement or disposal due to excessive degradation.

When comparing the voltage profiles VP1, VP2, VP3, and VP4, it can be seen that the voltage profile VP2 is located above the voltage profile VP1 (high voltage side), the voltage profile VP3 is located above the voltage profile VP2, and the voltage profile VP4 is located above the voltage profile VP3, based on the horizontal axis indicating capacity. In addition, it can be seen from FIG. 2 that the capacity value (for example, full charge capacity) corresponding to the upper limit (for example, 4.2[V]) of the allowable voltage range gradually decreases from the voltage profile VP1 to the voltage profile VP4.

That is, at the same capacity, the voltage of the voltage profile VP2 is higher than the voltage of the voltage profile VP1, the voltage of the voltage profile VP3 is higher than the voltage of the voltage profile VP2, and the voltage of the voltage profile VP4 is higher than the voltage of the voltage profile VP3. The reason is that the maximum capacity is reduced by degradation, and the voltage rises fast during charging.

Referring to FIG. 3, differential capacity profiles DQP1, DQP2, DQP3, DQP4 are shown. The differential capacity profiles DQP1, DQP2, DQP3, DQP4 may be acquired as a result of applying differentiation to the voltage profiles VP1, VP2, VP3, VP4 shown in FIG. 2. Specifically, the differential capacity profiles DQP1, DQP2, DQP3, DQP4 represent a correspondence relationship between the voltage V of the voltage profiles VP1, VP2, VP3, VP4 and differential capacity dQ/dV, respectively. The differential capacity (or differential capacity value) which is the parameter indicated by the symbol dQ/dV refers to a ratio of capacity change dQ to voltage change dV. The differential capacity profiles DQP1, DQP2, DQP3, DQP4 may be derivatives of the voltage profiles VP1, VP2, VP3, VP4, respectively.

The differential capacity profile DQP1 (also referred to as 'initial differential capacity profile') may represent differential information of the capacity-voltage characteristics acquired from the charge/discharge test of the test cell at the first time. Each peak in a differential capacity profile may be the result of phase transition reaction in specific electrode active material(s).

Meanwhile, the inventors have recognized through many experiments and verifications that when the degradation deviation between active materials is very high, little or no phase transition reaction occurs in a specific active material, and as a result, the total number of peaks in a differential capacity profile decreases. Referring to FIG. 3, the differential capacity profiles DQP1, DQP2, DQP3 have a total of four peaks over the allowable voltage range, whereas the differential capacity profile DQP4 in the most degraded state has a total of three peaks over the allowable voltage range.

Each of sub-voltage ranges ΔV₁, ΔV₂, ΔV₃, ΔV₄ may be set to correspond to each peak of the differential capacity profile DQP1. For example, the boundary of two adjacent sub-voltage ranges may be equal to the average voltage value of two peaks of the two sub-voltage ranges. Each sub-voltage range may be preset by a user, or may be determined by the processor 320.

In particular, the maximum differential capacity difference between the differential capacity profiles DQP1, DQP4 in the specific sub-voltage range ΔV₂ may be much larger than the maximum differential capacity differences between the differential capacity profiles DQP1, DQP4 in the other sub-voltage ranges ΔV₁, ΔV₃, ΔV₄. The maximum differential capacity difference between the differential capacity profiles DQP1, DQP4 in a sub-voltage range may indicate a difference between the differential capacity value of the degradation feature point of the differential capacity profile DQP1 and the differential capacity value of the degradation feature point of the differential capacity profile DQP4.

In this case, capacity-voltage relationship characteristics information in the specific sub-voltage range ΔV₂ ('voltage range of interest') may include information about the degradation state of the battery cell BC.

The inventors have recognized that the specific sub-voltage range to be analyzed when diagnosing the degradation state of the battery cell BC may be preset based on the charge/discharge test result of the test cell(s).

FIG. 4 is an enlarged view of a part of the differential capacity profiles DQP1, DQP2, DQP3, DQP4 corresponding to the specific sub-voltage range ΔV₂ in FIG. 3.

For each diagnosis cycle, the type of degradation feature point may be identified as any one of 'peak' and 'valley'. In this specification, the peak may signify 'local maximum point', and the valley may signify 'local minimum point'.

Referring to FIG. 4, within the specific sub-voltage range ΔV₂, the differential capacity profiles DQP1, DQP2, DQP3 have a single peak Cₐ, C_{b}, C_{c} without a valley, whereas the differential capacity profile DQP4 has a single valley C_{d} without a peak. To ease the detection of the degradation feature point, the processor 320 may perform the operation of detecting the degradation feature point after smoothing each of the differential capacity profiles DQP1, DQP2, DQP3, DQP4. The smoothing of the differential capacity profile may use one of known smoothing techniques such as a moving average filter or an exponential smoothing filter, or a combination thereof.

The peak C_{b} of the differential capacity profile DQP2 has a smaller differential capacity value than the peak Cₐ of the differential capacity profile DQP1, and the peak C_{c} of the differential capacity profile DQP3 has a smaller differential capacity value than the peak C_{b} of the differential capacity profile DQP2. The valley C_{d} of the differential capacity profile DQP4 has a smaller differential capacity value than the peak C_{c} of the differential capacity profile DQP3. From this, the inventors have recognized that (i) a first degradation characteristic of a decreasing differential capacity value of the degradation feature point detected within the specific sub-voltage range is followed by (ii) a second degradation characteristic of a change of the type of degradation feature point from peak to valley, as the battery cell BC degrades.

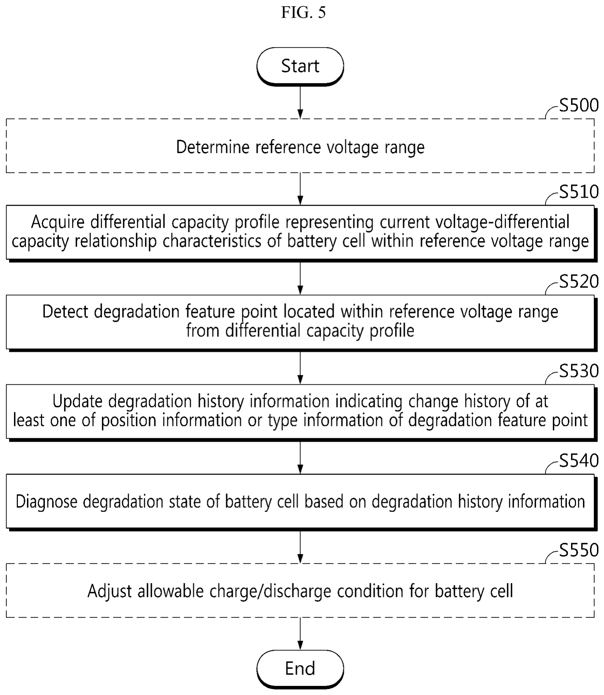

FIG. 5 is a flowchart referenced in briefly describing a battery diagnosis method according to another embodiment of the present disclosure. The method of FIG. 5 may be periodically or aperiodically performed by the battery diagnosis apparatus 302 in a repeated manner for at least a part of the whole life of the battery cell BC.

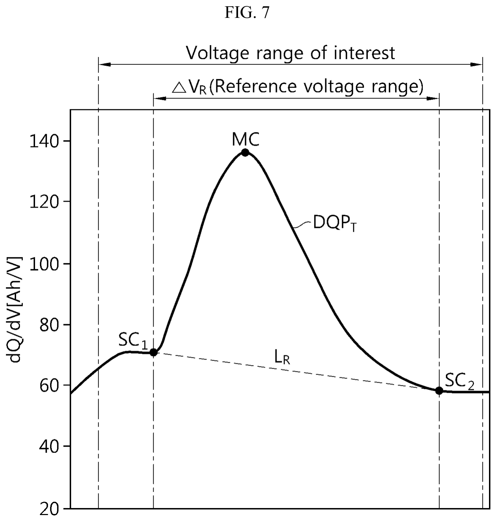

Referring to FIGS. 1 to 5, in step S500, the processor 320 may determine a reference voltage range (ΔV_{R} in FIG. 7) based on the initial differential capacity profile (DQP_{T} in FIG. 7) of the battery cell BC.

The initial differential capacity profile DQP_{T} represents the voltage-differential capacity relationship characteristics of the fresh battery cell BC and may be recorded in the memory unit 330. The differential capacity profile DQP1 shown in FIG. 3 or the differential capacity profile (see FIG. 7) acquired through the first charge/discharge cycle of the fresh battery cell BC may be used as the initial differential capacity profile DQP_{T}.

Alternatively, the reference voltage range may be preset. In this case, the step S500 is optional and may be omitted from the method of FIG. 5.

In step S510, the processor 320 acquires a differential capacity profile representing the current voltage-differential capacity relationship characteristics of the battery cell BC within the reference voltage range.

In step S520, the processor 320 detects a degradation feature point located within the reference voltage range from the differential capacity profile determined in the step S510.

In step S530, the processor 320 updates degradation history information indicating a change history of at least one of position information or type information of the degradation feature point based on the detection result of the degradation feature point. The position information of the degradation feature point for each diagnosis cycle includes the differential capacity value of the degradation feature point and may further include the voltage value of the degradation feature point. The type information of the degradation feature point for each diagnosis cycle may indicate the type of the degradation feature point identified among peak and valley.

The degradation history information may indicate which direction and how much the degradation feature point has changed for a period of time from the past specific time of the battery cell BC (for example, when the battery cell BC is new) to the present time. In addition, the degradation history information may indicate whether the type of the degradation feature point is maintained as peak or has changed from peak to valley.

In step S540, the processor 320 diagnoses the degradation state of the battery cell BC based on the degradation history information updated by the step S530.

In step S550, the processor 320 adjusts the allowable charge/discharge condition for the battery cell BC based on the diagnosis result of the degradation state of the battery cell BC. The step S550 is optional and may be omitted from the method of FIG. 5 where necessary.

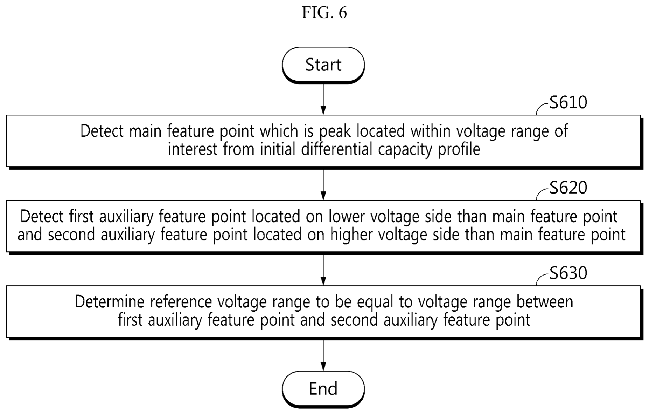

FIG. 6 is a flowchart schematically showing the sub-steps that may be included in the step S500 of FIG. 5, and FIG. 7 is a diagram referenced in describing the method of FIG. 6.

Referring to FIGS. 6 and 7, in step S610, the processor 320 detects a main feature point which is a peak located within the voltage range of interest, from the initial differential capacity profile DQP_{T} of the battery cell BC. The voltage range of interest may be the preset voltage range in which a single peak has been identified.

When the initial differential capacity profile DQP_{T} is acquired from the capacity-voltage information of the test cell, the main feature point MC of FIG. 7 may indicate the peak Cₐ of FIG. 4. In contrast, when the initial differential capacity profile DQP_{T} is acquired from the initial capacity-voltage information of the battery cell BC, the main feature point MC of FIG. 7 may be different from the peak Cₐ of FIG. 4.

In step S620, the processor 320 determines (detects), from the initial differential capacity profile DQP_{T}, a first auxiliary feature point SC₁ located on lower voltage side than the main feature point MC and a second auxiliary feature point SC₂ located on higher voltage side than the main feature point.

The type of at least one of the first auxiliary feature point SC₁ or the second auxiliary feature point SC₂ may be an inflection point. The inflection point of a differential capacity profile is a point at which the sign of the slope of the differential capacity profile changes from negative to positive or from positive to negative, and the change ratio of dQ/dV at the inflection point may be 0.

When two or more inflection points are present on the lower voltage side than the main feature point MC, the inflection point having the smallest voltage difference from the main feature point MC may be determined as the first auxiliary feature point SC₁. Likewise, when two or more inflection points are present on the higher voltage side than the main feature point MC, the inflection point having the smallest voltage difference from the main feature point MC may be determined as the second auxiliary feature point SC₂.

In step S630, the reference voltage range ΔV_{R} is determined to be equal to the voltage range between the first auxiliary feature point SC₁ and the second auxiliary feature point SC₂.

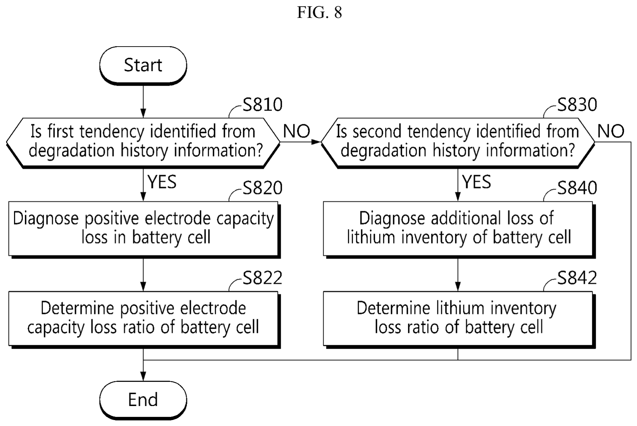

According to the present disclosure, the analysis of the capacity-voltage relationship characteristics information of the battery cell BC in the reference voltage range ΔV_{R} instead of the entire voltage range provides a technical advantage of reducing the computational complexity and the time required to draw the diagnosis result. The reference line L_{R} shown in FIG. 7 is a straight line connecting the first auxiliary feature point SC₁ and the second auxiliary feature point SC₂, and is used to identify the tendency of the degradation feature point as described below with reference to FIG. 8. The information that defines the reference line L_{R} may be determined by the method according to FIG. 7, or may be recorded in the memory unit 330.

When the first auxiliary feature point SC₁ and the second auxiliary feature point SC₂ are determined according to the above-described method, a single closed region having the main feature point MC as a single peak is defined by the reference line L_{R} and the initial differential capacity profile DQP_{T}. Accordingly, the reference line L_{R} may be used as a clear and efficient diagnostic criterion based on the information (i.e., differential capacity value and/or type) of the degradation feature point that changes as the battery cell BC degrades.

FIG. 8 is a flowchart schematically showing the sub-steps that may be included in the step S540 of FIG. 5.

Referring to FIG. 8, in step S810, the processor 320 determines whether a first tendency of the degradation feature point to get close to the reference line L_{R} above the reference line L_{R} is identified from the degradation history information updated by the step S530. For example, referring back to FIG. 4, the change from Cₐ to C_{b} shows the first tendency.

When a value of the step S810 is "YES", step S820 is performed. When the value of step S810 is "NO", step S830 may be performed.

In the step S820, the processor 320 diagnoses that positive electrode capacity loss of the battery cell BC occurred. In other words, it may be diagnosed that the positive electrode capacity loss is the main cause of degradation, and little or no available lithium loss-induced degradation occurred yet. For reference, the available lithium loss may be referred to as 'Loss of Lithium Inventory (LLI)'.

In step S822, the processor 320 may determine a positive electrode capacity loss ratio of the battery cell BC according to a difference between the current differential capacity value of the degradation feature point and the initial differential capacity value. The initial differential capacity value may be equal to the differential capacity value of the main feature point MC. The processor 320 may determine the positive electrode capacity loss ratio of the battery cell BC by using first relationship data (indicating the correspondence relationship between the differential capacity difference and the positive electrode capacity loss ratio) associated with the first tendency, recorded in the memory unit 330.

In the step S830, the processor 320 determines whether a second tendency of the degradation feature point to move away from the reference line L_{R} below the reference line L_{R} is identified from the degradation history information updated by the step S530. The identification condition of the second tendency may include at least one of (i) a shift of the degradation feature point above from the reference line L_{R} down below the reference line L_{R}, or (ii) a change of the type of degradation feature point from peak to valley. For example, referring back to FIG. 4, the change from C_{c} to C_{d} and/or the change from C_{b} to C_{c} shows the second tendency. When a value of the step S830 is "YES", step S840 may be performed. When the value of the step S830 is "NO", the method according to FIG. 8 may end.

In the step S840, the processor 320 diagnoses that additional loss of lithium inventory of the battery cell BC occurred. That is, it may be diagnosed that in addition to the positive electrode capacity loss, loss of lithium inventory-induced degradation progressed at a considerable level, or loss of lithium inventory-induced degradation will get worse. The loss of lithium inventory may be a type of degradation that comes after the positive electrode capacity loss. When the positive electrode capacity loss has already occurred and the loss of lithium inventory additionally occurred, the second tendency indicating that accelerated degradation is happening or will happen may be identified from the degradation history information.

According to the inventors' analysis results after disassembling the plurality of test cells, when the first tendency is identified, little or no loss of lithium inventory is detected, but when the second tendency is identified, loss of lithium inventory is definitely detected.

In step S842, the processor 320 determines a lithium inventory loss ratio of the battery cell BC according to a difference between the current differential capacity value of the degradation feature point and the differential capacity value of the reference line L_{R}. The difference between the current differential capacity value of the degradation feature point and the differential capacity value of the reference line L_{R} may be referred to as differential capacity difference.

The differential capacity value of the reference line L_{R} that is compared with the current differential capacity value of the degradation feature point may be a differential capacity value at the intersection between a vertical line having the voltage value of the degradation feature point and the reference line L_{R}.

The differential capacity value of the reference line L_{R} may be determined in reliance on the degradation feature point. Specifically, the differential capacity value of the reference line L_{R} may be a differential capacity value mapped to the same voltage value as the voltage value of the degradation feature point. Accordingly, the degradation feature point above the reference line L_{R} may represent that the differential capacity value of the reference line L_{R} at the same voltage value as the degradation feature point is smaller than the differential capacity value of the degradation feature point. Likewise, the degradation feature point below the reference line L_{R} may represent that the differential capacity value of the reference line L_{R} at the same voltage value as the degradation feature point is larger than the differential capacity value of the degradation feature point.

The processor 320 may determine the lithium inventory loss ratio of the battery cell BC by using second relationship data (indicating the correspondence relationship between the differential capacity difference and the lithium inventory loss ratio) associated with the second tendency, recorded in the memory unit 330.

The steps S822 and S842 are optional, and at least one of them may be omitted from the method of FIG. 8.

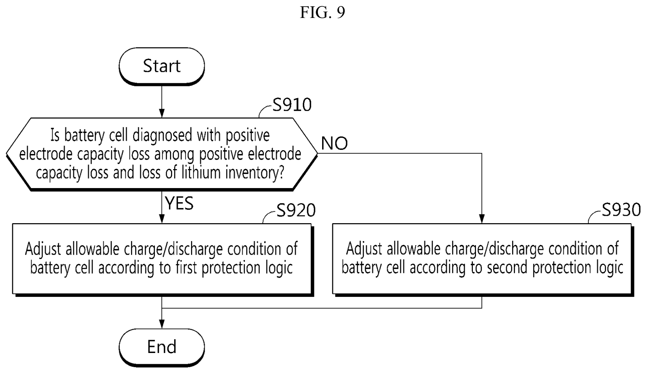

FIG. 9 is a flowchart schematically showing the sub-steps that may be included in the step S550 of FIG. 5.

Referring to FIG. 9, in step S910, the processor 320 determines whether it was diagnosed that only the positive electrode capacity loss has occurred among the positive electrode capacity loss and the loss of lithium inventory based on the diagnosis result in the step S540. When a value of the step S910 is "YES", step S920 may be performed. The value of the step S910 being "NO" represents that the battery cell BC is diagnosed with the positive electrode capacity loss and the loss of lithium inventory. When the value of the step S910 is "NO", step S930 may be performed.

In step S920, the processor 320 adjusts the allowable charge/discharge condition for the battery cell BC according to a first protection logic. The allowable charge/discharge condition may be data that defines an allowable value for at least one item of the upper limit of charging voltage, the lower limit of discharging voltage, the maximum charging current, the maximum discharging current, the maximum depth of charge (the maximum SOC that can be charged), the maximum depth of discharge (the minimum SOC that can be discharged) or the maximum temperature of the battery cell BC.

The first protection logic may include an operation of reducing at least one item of the previous allowable charge/discharge condition by a first predetermined percentage or by a first predetermined value. For example, each time the first protection logic is executed, the upper limit of charging voltage may be reduced by 1%.

In step S930, the processor 320 adjusts the allowable charge/discharge condition for the battery cell BC according to a second protection logic.

The second protection logic may include an operation of reducing at least one item of the previous allowable charge/discharge condition by a second predetermined percentage (larger than the first predetermined percentage) or a second predetermined value (larger than the first predetermined value). For example, each time the second protection logic is executed, the upper limit of charging voltage may be reduced by 2%.

The second protection logic may further include an operation of reducing a different item other than the item that has been reduced by the first protection logic. For example, each time the second protection logic is executed, the first protection logic may be basically executed to reduce the upper limit of charging voltage by 1%, and besides, an additional operation of reducing each of the maximum charging current and the maximum discharging current by 3% may be performed.

The embodiments of the present disclosure as described above are not embodied only through an apparatus and method, and may be implemented through programs that perform the functions corresponding to the exemplary configurations of the present disclosure or recording media having the programs recorded thereon, and such implementation may be easily achieved by those skilled in the art from the disclosure of the embodiments previously described.

Although the present disclosure has been hereinabove described with regard to certain embodiments and drawings, the present disclosure is not limited thereto and it is obvious to those skilled in the art that various modifications and changes may be made thereto within the technical aspects of the present disclosure and the scope of the appended claims and their equivalents.

Additionally, as many substitutions, modifications and changes may be made to the present disclosure as described above by those skilled in the art without departing from the technical aspects of the present disclosure, the present disclosure is not limited by the above-described embodiments and the accompanying drawings, and some or all of the embodiments may be selectively combined to allow various modifications.

## Claims

1. A battery diagnosis method comprising:
detecting a degradation feature point located within a reference voltage range from a differential capacity profile representing voltage-differential capacity relationship characteristics of a battery cell in the reference voltage range;
updating degradation history information indicating a change history of at least one of position information or type information of the degradation feature point based on a result of detecting the degradation feature point; and
diagnosing a degradation state of the battery cell based on the updated degradation history information.

2. The battery diagnosis method according to claim 1, further comprising:
determining a voltage profile of the battery cell with respect to the reference voltage range by curve fitting a voltage-current data set acquired with a change in voltage of the battery cell over the reference voltage range; and
acquiring the differential capacity profile by differentiating the voltage profile.

3. The battery diagnosis method according to claim 1,
wherein the diagnosing of the degradation state of the battery cell comprises diagnosing that a positive electrode capacity loss of the battery cell occurred when a first tendency of the degradation feature point to get close to a reference line above the reference line is identified from the updated degradation history information.

4. The battery diagnosis method according to claim 3,
wherein the diagnosing of the degradation state of the battery cell further comprises determining a positive electrode capacity loss ratio of the battery cell by comparing a current differential capacity value of the degradation feature point with an initial differential capacity value when it is diagnosed that the positive electrode capacity loss occurred in the battery cell.

5. The battery diagnosis method according to claim 1,
wherein the diagnosing of the degradation state of the battery cell comprises diagnosing that in addition to the positive electrode capacity loss of the battery cell, an additional loss of lithium inventory occurred when a second tendency of the degradation feature point to move away from the reference line below the reference line is identified from the updated degradation history information.

6. The battery diagnosis method according to claim 5,
wherein the diagnosing of the degradation state of the battery cell further comprises determining a lithium inventory loss ratio of the battery cell according to a difference between a current differential capacity value of the degradation feature point and a differential capacity value of the reference line when it is diagnosed that the loss of lithium inventory of the battery cell occurred.

7. The battery diagnosis method according to any one of claims 3 to 6, further comprising:
before the determining of the differential capacity profile of the battery cell with respect to the reference voltage range,
determining the reference voltage range based on an initial differential capacity profile of the battery cell.

8. The battery diagnosis method according to claim 7,
wherein the determining of the reference voltage range comprises:
detecting a main feature point which is a peak located within a predetermined voltage range of interest from the initial differential capacity profile;
detecting a first auxiliary feature point located on lower voltage side than the main feature point and a second auxiliary feature point located on higher voltage side than the main feature point; and
determining the reference voltage range to be equal to a voltage range between the first auxiliary feature point and the second auxiliary feature point.

9. The battery diagnosis method according to claim 8,
wherein the reference line is a straight line passing through the first auxiliary feature point and the second auxiliary feature point.

10. A battery diagnosis apparatus comprising:
a processor to generate a differential capacity profile representing voltage-differential capacity relationship characteristics of a battery cell in a reference voltage range,
wherein the processor is configured to:
detect a degradation feature point located within the reference voltage range from the differential capacity profile,
update degradation history information indicating a change history of at least one of position information or type information of the degradation feature point based on a result of detecting the degradation feature point, and
diagnose a degradation state of the battery cell based on the updated degradation history information.

11. The battery diagnosis apparatus according to claim 10,
wherein the processor is configured to:
diagnose that a positive electrode capacity loss of the battery cell occurred when a first tendency of the degradation feature point to get close to a reference line above the reference line is identified from the updated degradation history information.

12. The battery diagnosis apparatus according to claim 10,
wherein the processor is configured to:
diagnose that in addition to the positive electrode capacity loss of the battery cell, an additional loss of lithium inventory occurred when a second tendency of the degradation feature point to move away from the reference line below the reference line is identified from the updated degradation history information.

13. The battery diagnosis apparatus according to claim 11,
wherein the processor is configured to:
determine the reference voltage range based on an initial differential capacity profile of the battery cell, before determining the differential capacity profile.

14. A battery pack comprising the battery diagnosis apparatus according to any one of claims 10 to 13.

15. A battery system comprising the battery diagnosis apparatus according to any one of claims 10 to 13.
